# EUROPÄISCHE PATENTSCHRIFT

(11) **EP 1 186 370 B1**
(45) Veröffentlichungstag und Bekanntmachung des Hinweises auf die Patenterteilung: **09.05.2007**
(21) Anmeldenummer: 01117474.5
(22) Anmeldetag: 19.07.2001
(51) Int. Cl.: B23K 26/10, H05K 3/32, B23K 26/20, B23K 26/06, H01R 43/02, B23K 26/32

(54) **Verfahren und Vorrichtung zur Erzeugung einer Laserschweissverbindung**
Process and device for producing a laser weld joint
Procédé et dispositif pour produire un joint soudé par laser

(30) Priorität: 28.07.2000 DE 10036901
(43) Veröffentlichungstag der Anmeldung: 13.03.2002
(73) Patentinhaber: SIEMENS AKTIENGESELLSCHAFT, 80333 München (DE)
(72) Erfinder: Müller, Ronny, 92449 Steinberg (DE); Weller, Rainer, 54552 Dreis-Brück (DE)

(56) Entgegenhaltungen:
- EP-A- 0 326 020
- EP-A- 0 891 835
- DE-A- 4 016 033
- FR-A- 2 652 292
- US-A- 4 978 835
- US-A- 5 324 913
- US-A- 5 659 656
- US-A- 5 676 865
- PATENT ABSTRACTS OF JAPAN vol. 011, no. 057 (M-564), 21. Februar 1987 (1987-02-21) -& JP 61 219467 A (HITACHI LTD), 29. September 1986 (1986-09-29)
- PATENT ABSTRACTS OF JAPAN vol. 012, no. 248 (C-511), 13. Juli 1988 (1988-07-13) -& JP 63 038545 A (FURUKAWA ELECTRIC CO LTD:THE), 19. Februar 1988 (1988-02-19)
- PATENT ABSTRACTS OF JAPAN vol. 017, no. 395 (M-1451), 23. Juli 1993 (1993-07-23) -& JP 05 077071 A (NIPPONDENSO CO LTD), 30. März 1993 (1993-03-30)
- PATENT ABSTRACTS OF JAPAN vol. 017, no. 691 (E-1479), 17. Dezember 1993 (1993-12-17) & JP 05 235535 A (MATSUSHITA ELECTRIC IND CO LTD), 10. September 1993 (1993-09-10)

## Beschreibung

Die Erfindung betrifft ein Verfahren und eine Vorrichtung zur Erzeugung einer Laserschweißverbindung zwischen einer flexiblen Metallfolie, insbesondere Cu-Folie, und einem metallischen Kontaktpartner.

Derartige Verfahren und Vorrichtungen sind in besonderem Maße für die Technik der Bestückung flexibler Leiterplatten mit elektrischen Bauelementen von Bedeutung. Bekannte und für derartige Zwecke erprobte Verfahren sind das Nieten, Löten und Drahtbonden. Ferner sind Laserschweiß- und Laserlötverfahren bekannt, bei denen die für die Erzeugung einer elektrischen Kontaktverbindung erforderliche Energie in Form von Laserstrahlung in die Fügepartner eingebracht wird.

Laserbestrahlungsverfahren weisen eine Reihe von prinzipbedingten Vorteilen (hohe Prozeßvariabilität, Wegfall von mechanischen Werkzeugen, hohe Verschleißfreiheit usw.) gegenüber den genannten mechanischen Kontaktierungsverfahren auf. Nachteilig bei den Laserbestrahlungsverfahren ist jedoch, daß die Qualität der erzielten Verbindungen häufig variiert und in bezug auf ihre mechanischen und elektrischen Eigenschaften nicht selten zu wünschen übrig läßt.

In der den nächstliegenden Stand der Technik repräsentierenden Patentschrift US 5,676,865 ist ein Verfahren zur Realisierung einer Schweißverbindung zwischen einer flexiblen Leiterplatte und einem metallischen Leiter beschrieben. Bei diesem Verfahren werden zunächst gegenüberliegende Öffnungen in die boden- und deckenseitigen Isolationsschichten der flexiblen Leiterplatte eingebracht, so daß eine dazwischen verlaufende Leiterbahn in den Öffnungsbereichen beidseitig freiliegt. Die freiliegende Leiterbahn wird dann mit einem Zentralloch versehen. Nachfolgend wird der Lochrand der Leiterbahn so umgeformt, daß er mit einer Endfläche des elektrischen Leiters in Kontakt gelangt. Zuletzt wird die Leiterbahn mittels eines durch die rückwärtige Öffnung gerichteten Laserstrahls im Lochbereich an den Leiter angeschweißt.

Nachteilig bei diesen Verfahren ist, daß aufgrund des Zentrallochs relativ wenig Leiterbahnmaterial für den Schweißprozeß zur Verfügung steht und ferner ein definiertes Herunterbiegen des Lochrands auf den Leiter technische Probleme bereitet. Aus diesen Gründen kann auch dieses Verfahren die praktischen Anforderungen in bezug auf die Reproduzierbarkeit der Herstellung qualitativ guter Kontakte nicht garantieren.

Der Erfindung liegt die Aufgabe zugrunde, ein Verfahren und eine Vorrichtung zur reproduzierbaren Herstellung einer dauerhaften und niederohmigen Schweißverbindung zwischen einer Metallfolie, insbesondere Cu-Folie, und einem metallischen Kontaktpartner zu schaffen.

Die Aufgabenstellung wird durch die Merkmale der Ansprüche 1 und 10 gelöst.

Die Erfindung beruht auf der Erkenntnis, daß eine entscheidende Voraussetzung für die Erzeugung von Schweißverbindungen mit einwandfreien elektromechanischen Kontakteigenschaften eine definierte und spaltfreie Anlage der Metallfolie an der Verbindungsfläche des Kontaktpartners ist. Nur unter dieser Voraussetzung gelingt die Herstellung reproduzierbarer, qualitativ hochwertiger schmelzmetallurgischer Verbindungen durch Laserschweißen. Das Anpressen der Metallfolie an die Verbindungsfläche des Kontaktpartners wird erfindungsgemäß durch eine spezielle Niederhaltetechnik gewährleistet.

Eine vorteilhafte Verfahrensvariante kennzeichnet sich dadurch, daß das Laserlicht durch eine Durchtrittsöffnung des Niederhalters auf die Metallfolie gelangt. Auf diese Weise wird sichergestellt, daß die Andruckzone den Beleuchtungsbereich allseitig umgibt. Dabei kann ein vollständiger Formschluß oder Nullspalt im Anlagebereich zwischen der flexiblen Metallfolie und der Verbindungsfläche des metallischen Kontaktpartners sicher gewährleistet werden.

Darüber hinaus wird die Qualität der erhaltenen Schweißverbindung auch durch die Materialwahl der Fügepartner beeinflußt. Bei Verwendung einer Cu-Metallfolie hat sich gezeigt, daß hochwertige Verbindungen mit einem aus einer Bronze-Legierung bestehenden metallischen Kontaktpartner im wesentlichen nur bis zu einem Zinnanteil von maximal 14% möglich sind.

Ferner hat sich gezeigt, daß der Nickel- und Zinkgehalt einer solchen Bronze-Legierung jeweils nicht über 0,1% liegen sollte, da bei höheren Anteilen der genannten Metalle sich die Reproduzierbarkeit der erzielten Schweißverbindungen deutlich verringert. Bezüglich Blei ist ein Anteil von maximal etwa 1% aktzeptabel.

Ein wichtiger Anwendungsbereich der Erfindung besteht in der (automatisierten) Bestückung einer flexiblen Leiterplatte (deren Leiterbahnen die Metallfolie realisieren) mit elektronischen Bauelementen (deren Kontaktstifte die metallischen Kontaktpartner darstellen). Die mit der Erfindung erzielten elektromechanischen Kontakteigenschaften (hohe mechanische Festigkeit, niedriger ohmscher Übergangswiderstand) sowie die gute Reproduzierbarkeit der Kontaktherstellung sind gerade für diesen Anwendungsfall von zentraler Bedeutung.

Eine konstruktiv vorteilhafte Ausführungsvariante des in der erfindungsgemäßen Vorrichtung zur Erzeugung einer Laserschweißverbindung eingesetzten Niederhalters kennzeichnet sich dadurch, daß der Niederhalter von einer Druckfeder beaufschlagt und in Richtung der Federkraft beweglich an einem Tragkörper angebracht ist. Dadurch wird erreicht, daß die von dem Niederhalter auf die Metallfolie (oder flexible Leiterplatte) ausgeübte Andruckkraft von der Druckfeder erzeugt und daher gezielt und feinfühlig über die Wahl eines geeigneten Abstandes zwischen dem Tragkörper und der Metallfolie (flexible Leiterplatte) einstellbar ist.

Die Erfindung wird nachfolgend anhand eines Ausführungsbeispiels unter Bezugnahme auf die Zeichnung näher erläutert; in dieser zeigt
- Fig. 1: eine schematische Schnittdarstellung einer Anordnung bestehend aus drei Niederhaltern, einer flexiblen Leiterplatte und drei Kontaktpartnern; und
- Fig. 2: eine vereinfachte, schematische Schnittdarstellung einer erfindungsgemäßen Vorrichtung.

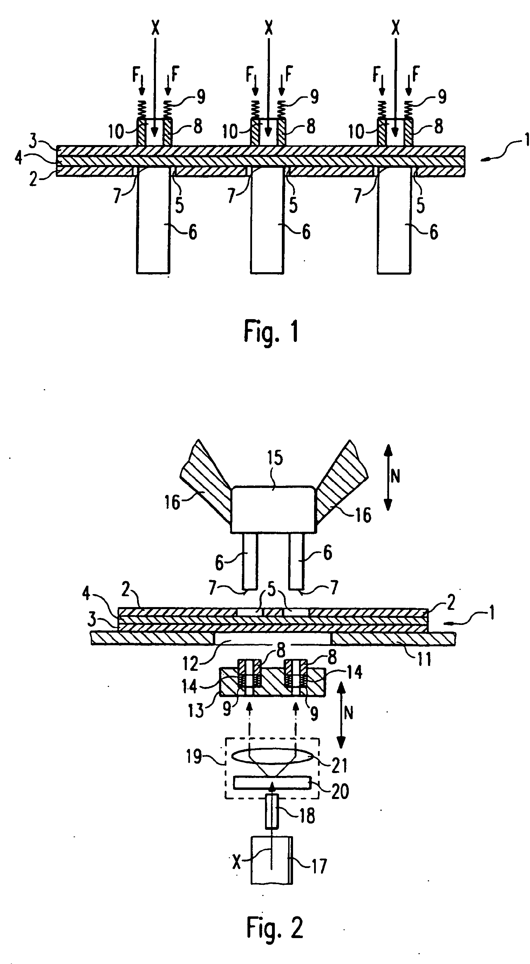

Fig. 1 zeigt eine flexible Leiterplatte 1, die aus zwei parallel verlaufenden Isolationsschichten 2, 3 und einer dazwischen liegenden Metallfolie (Leiterbahn) 4 aufgebaut ist. Derartige flexible Leiterplatten werden in vielfältigen Ausführungen hergestellt und als elektrische Verbindungselemente sowie als Träger für Elektronikschaltungen verwendet.

Die untere Isolationsschicht 2 weist drei Öffnungen 5 auf, an deren Böden die Metallfolie 4 frei liegt.

Jede Öffnung 5 wird von einem Metallstift 6 durchlaufen, welcher mit seiner der flexiblen Leiterplatte 1 zugewandten Endfläche 7 ganzflächig an der Metallfolie 4 anliegt.

Die Metallstifte 6 werden in Fig. 1 als ortsfest betrachtet. Auf der gegenüberliegenden Seite der Leiterplatte 1 befinden sich Niederhalter 8, die mit einer durch Druckfedern 9 vorgegebenen Andruckkraft F auf die obere Isolationsschicht 3 der Leiterplatte 1 drücken. Die Lage der Niederhalter 8 ist dabei so gewählt, daß sie exakt axial ausgerichtet mit den jeweils gegenüberliegenden angeordneten Metallstiften 6 sind.

Die Niederhalter 8 können in Form eines Hohlzylinders mit ringförmigen oder rechteckigen Querschnitt ausgebildet sein. Die Öffnung 10 ermöglicht die Einkopplung von Laserlicht X in die flexible Leiterplatte 1.

Die Isolationsschichten 2, 3 der flexiblen Leiterplatte 1 können beispielsweise aus Polyimid oder einem anderen geeigneten Kunststoff oder Lackmaterial bestehen. Die Metallfolie 4 ist vorzugsweise aus Cu. Anstelle der in Fig. 1 dargestellten Leiterplatte 1 mit einseitigem Zugriff (Öffnungen 5) kann auch eine flexible Leiterplatte mit beidseitigem Zugriff verwendet werden. Bei einer flexiblen Leiterplatte mit beidseitigem Zugriff ist auch die obere Isolationsschicht 3 mit Öffnungen versehen, welche den Öffnungen 5 gegenüberliegen. In diesem Fall strecken sich die Niederhalter 8 durch diese Öffnungen hindurch und drücken direkt auf die Metallfolie 4 auf.

Die Erzeugung dieser (in Fig. 1 nicht dargestellten) Zugriffsöffnungen in der oberen Isolationsschicht 3 besteht darin, daß vor dem Positionieren der Niederhalter 8 in den dargestellten Positionen zunächst mittels des Laserlichts X die genannten Zugriffsöffnungen in die Isolationsschicht 3 gebrannt werden. Der Laser erfüllt in diesem Fall eine Doppelfunktion, da er sowohl für die Herstellung der Zugriffsöffnungen (nicht dargestellt) als auch für die erfindungsgemäße Erzeugung der Schweißverbindungen eingesetzt wird.

Nachfolgend wird anhand Fig. 1 ein erfindungsgemäßer Ablauf zur Erzeugung einer Laserschweißverbindung beschrieben.

Zunächst wird die flexible Leiterplatte 1 mittels einer geeigneten Handhabungseinrichtung (siehe beispielsweise auch Fig. 2) in Position gebracht und so auf die lagefesten Metallstifte 6 (z.B. Kontaktbeine von Bauteilen) niedergebracht, daß die Metallstifte 6 werden durch die Öffnungen 5 hindurch in Anlage an die Metallfolie 4 gelangen. Ohne die Ausübung eines Gegendrucks von der gegenüberliegenden Seite der Leiterplatte 1 kann keine für das erfindungsgemäße Verfahren ausreichend spaltfreie Anlage der Endflächen 7 der Metallstifte 6 an die Metallfolie 4 erzielt werden. Die erforderliche Spaltfreiheit zwischen den Kontaktpartnern wird erst durch den lokal auf die rückseitige Isolationsschicht 3 drückenden Niederhalter 8 bewirkt. Zu diesem Zweck werden die Niederhalter 8 in geeigneter Weise und ausgerichtet mit den Metallstiften 6 auf die Isolationsschicht 3 der Leiterplatte 1 abgesenkt. Die Federn 9 ermöglichen die Einstellung einer definierten Andruckkraft, die ausreichend für die Erzielung und Sicherstellung der Spaltfreiheit zu Beginn des Schweißprozesses ist.

In einem nächsten Schritt erfolgt die Erzeugung der Schweißverbindungen. Als Laserquelle können ein oder mehrere Nd:YAG-Laser eingesetzt werden. Der Laserstrahl X trifft von oben auf die Isolationsschicht 3, durchläuft diese und dringt bis etwa 1 mm tief in die Fügepartner (Metallfolie 4 und Metallstift 6) ein. Die dabei entstehende Schmelze verschweißt die beiden Fügepartner. Anders als beim Laserlöten werden hierfür keine Zusatzwerkstoffe (Lot) benötigt.

Bei dem Schweißschritt entsteht eine kreisscheibenförmige Verbindungszone (Schweißpunkt) mit einem Durchmesser von 0,6 bis 0,9 mm. Der Durchmesser ist abhängig von der Laseroptik und kann durch Verstellen derselben variiert und optimiert werden. Die Schweißenergie hängt von dem Lichtfleckdurchmesser (etwa 0,3 bis 0,6 mmm) des Laserlichts auf der flexiblen Leiterplatte 1 und der Pulslänge des Laserlichts ab und beträgt zwischen 8 J und 18 J. Die Pulsspitzenleistung erreicht bei einer Pulszeit von 3 ms bis 10 ms etwa 2 kW bis 3 kW. Es kann mit einer mittleren Leistung von 100 bis 200 W des Nd:YAG-Lasers (Wellenlänge 1,06 µm) gearbeitet werden. Die genannten Laserparameter sind ferner von der Materialwahl und der Geometrie der Fügepartner abhängig.

Gute Schweißergebnisse wurden mit Metallstiften 6 aus CuSnX-Legierungen erhalten, wobei X den Zinnanteil der Legierung bezeichnet. Die durchgeführten Versuche deuten darauf hin, daß sämtliche CuSnX-Legierungen mit einem Zinnanteil von bis zu X=14% geschweißt werden können. Problematisch sind Anteile von Blei, Nickel oder Zink. Bei Anteilen von Blei über 1% und Anteilen von Nickel oder Zink über etwa 0,1% können aufgrund eines zu erruptiven Werkstoffverhahltens keine reproduzierbaren Schweißergebnisse erzielt werden.

Geeignete Bronze-Legierungen sind beispielsweise CuSn5, CuSn5-Ag, CuSn6, CuSn6-Ag, CuSn14Pb, CuSnl4Pb-Ag und CuSn5Pb1-Ag.

Fig. 2 zeigt ein Beispiel für eine erfindungsgemäße Vorrichtung zur Durchführung des beschriebenen Verfahrens. Dieselben oder vergleichbare Teile wie in der Fig. 1 sind mit denselben Bezugszeichen versehen. Die flexible Leiterplatte 1 ist auf einer Halterung 11 mechanisch fixiert. Die Halterung weist in einem zentralen Bereich eine Montageöffnung 12 auf. Unterhalb der Montageöffnung 12 befindet sich ein Tragkörper 13, der in Normalrichtung (Doppelpfeil N) zu der durch den Träger 11 definierten Ebene längsverschieblich angebracht ist. In dem Tragkörper 13 sind zwei ebenfalls in Normalrichtung orientierte Aufnahmevertiefungen oder Buchsen 14 vorhanden, in welche die Niederhalter 8 gleitend verschiebbar und jeweils über die Federn 9 abgestützt eingesetzt sind.

Ein elektronisches Bauelement 15 wird über Manipulatorarme 16 oberhalb der flexiblen Leiterplatte 1 gehalten und in der Weise auf die Leiterplatte 1 (in Normalrichtung N) abgesenkt, daß die Kontaktbeine 6 des Bauelements 15 in die Öffnungen 5 der Isolationsschicht 2 eintreten und die Metallfolie 4 berühren. Der für die erfindungsgemäße Erzeugung der Schweißverbindung erforderliche Gegenanlagedruck wird dann durch eine kontrollierte Verschiebung des Tragkörpers 13 in Richtung zu dem Träger 11 hin aufgebaut. Durch eine Steuerung des Verfahrwegs (Abstand zwischen dem Träger 11 und einem Referenzpunkt des Tragkörpers 13) kann unter Berücksichtigung der Federkonstante der Druckfedern 9 eine gewünschte Gegendruckkraft eingestellt werden. Genausogut kann, wie bereits im Zusammenhang mit Fig. 1 erläutert, auch das Bauelement 15 lagefest und der Träger 11 verschiebbar ausgeführt sein.

Aus Fig. 2 ist ferner ersichtlich, daß das von einem Laser 17 erzeugte Laserlicht X über eine optische Faser 18 einem Laserkopf 19 zugeführt wird. Der Laserkopf 19 weist ein Laserlicht-Umlenksystem (Scannerspiegel) 20 und ein Planfeld-Objektiv (telezentrische Optik) 21 auf. Das Laserlicht-Umlenksystem 20 positioniert den Laserstrahl nacheinander auf die gewünschten Schweißstellen, während das Planfeld-Objektiv 21 dafür sorgt, daß die Laserstrahlen hinter dem Laserkopf 19 stets parallel und senkrecht zum Träger 11 verlaufen und eine identische Fokusebene aufweisen.

Ein wesentlicher Effekt der Erfindung besteht darin, daß durch das erfindungsgemäße Verfahren besonders niederohmige Übergangswiderstände erzeugt werden können. In Tabelle 1 sind die Übergangswiderstände (in mΩ) angegeben, die bei Messungen als Minimalwert, Maximalwert und Durchschnittswert für drei verschiedene Werkstoffe des Metallstiftes 6 erhalten wurden. Die Werte beziehen sich auf eine flexible Leiterplatte 1 mit einseitigem Zugriff. Der Tabelle 1 ist zu entnehmen, daß die Durchschnittswerte der gemessenen Übergangswiderstände in allen Fällen zwischen 0,56 und 0,64 mΩ liegen. Eine Versilberung einer CuSn6-Legierung bewirkt eine leichte Erhöhung des gemessenen Übergangswiderstandswerts.

**Tabelle 1**

| **Pin-Material** | **Versilbert** | **Übergangswiderstand** | | |
|---|---|---|---|---|
| | | ∅ | Max. | Min. |
| | | | | |
| CuSn6 | - | 0,56 | 0,77 | 0,42 |
| CuSn6 | Ag | 0,64 | 0,76 | 0,55 |
| CuSn14Pb | - | 0,57 | 0,75 | 0,43 |

Zum Vergleich sind in Tabelle 2 die Übergangswiderstände (in mΩ) angegeben, die bei anderen Verbindungstechnologien erreicht werden. Die gemessenen Übergangswiderstände betragen für diese bekannten Technologien 2,5 bis 7 mΩ und sind damit um ein Vielfaches höher als beim erfindungsgemäßen Laserschweißen.

**Tabelle 2**

| **Technologie** | **Übergangswiderstand in mΩ** |
|---|---|
| | |
| Bonden (300 *µ*m Al-Draht) auf Aluminium-platte | 2,75 |
| Bonden (300 *µ*m Al-Draht) auf Flexleiterplatte (chemisch Ni/Au) | 2,50 |
| Bonden (300 *µ*m Al-Draht) auf LTCC-Substrat (AgPd) | 3,00 bis 7,00 |
| Klebung zwischen LTCC-Substrat und Flexleiterplatte (chemisch Ni/Au) | 3,50 |

Bei einem Durchmesser der Schweißzone von etwa 0,6 bis 0,9 mm kann ohne weiteres eine Zugscherfestigkeit von etwa 25 bis 35 N erreicht werden.

## Patentansprüche

1. Verfahren zur Erzeugung einer Laserschweißverbindung zwischen einer flexiblen Metallfolie (4), insbesondere Cu-Folie einer flexiblen Leiterplatte (1) und einem metallischen Kontaktpartner (6), bei welchem
- eine Verbindungsfläche (7) des metallischen Kontaktpartners (6) in Anlage zu einem freiliegenden Bereich auf einer Seite der Metallfolie (4) gebracht wird,
- auf die gegenüberliegende Seite der Metallfolie (4) Laserlicht (X) gerichtet wird, derart, daß eine Öffnung in eine die Metallfolie (4) abdeckende Isolationsschicht (3) gebrannt wird,
- mittels einer von einem Niederhalter (8) auf die gegenüberliegende Seite der Metallfolie (4) ausgeübten Druckkraft eine spaltfreie Anlage der Metallfolie (4) an die Verbindungsfläche (7) des Kontaktpartners (6) sichergestellt wird, und
- durch Bestrahlen der Metallfolie (4) mit Laserlicht (X) durch die in die Isolationsschicht (3) gebrannte Öffnung eine Schweißverbindung zwischen der Metallfolie (4) und dem Kontaktpartner (6) gebildet wird.

2. Verfahren nach Anspruch 1,
**dadurch gekennzeichnet,**
- **daß** das Laserlicht (X) durch eine Durchtrittsöffnung (10) des Niederhalters (8) auf die Metallfolie (4) gelangt.

3. Verfahren nach einem der vorhergehenden Ansprüche,
**dadurch gekennzeichnet,**
- **daß** der metallische Kontaktpartner (6) aus einer Bronze-Legierung mit einem Zinnanteil von maximal 14% besteht.

4. Verfahren nach einem der vorhergehenden Ansprüche,
**dadurch gekennzeichnet,**
- **daß** der metallische Kontaktpartner (6) aus eine Bronze-Legierung mit einem Bleigehalt von maximal 1% besteht.

5. Verfahren nach einem der vorhergehenden Ansprüche,
**dadurch gekennzeichnet,**
- **daß** der metallische Kontaktpartner (6) aus einer Bronze-Legierung mit einem Nickel- oder Zinkgehalt von maximal 0,1% besteht.

6. Verfahren nach einem der vorhergehenden Ansprüche,
**dadurch gekennzeichnet,**
- **daß** der Durchmesser eines von dem Laser (17) auf der Metallfolie (4) erzeugten Lichtflecks zwischen 0,3 und 0,6 mm eingestellt wird.

7. Verfahren nach einem der vorhergehenden Ansprüche,
**dadurch gekennzeichnet,**
- **daß** zur Erzeugung der Schweißverbindung eine Schweißenergie von 8 bis 18 J eingesetzt wird.

8. Verfahren nach einem der vorhergehenden Ansprüche,
**dadurch gekennzeichnet,**
- **daß** bei einer Pulszeit von 3 ms bis 10 ms eine PulsSpitzenleistung von 2 bis 3 kW des Lasers (17) eingesetzt wird.

9. Verfahren nach einem der vorhergehenden Ansprüche,
**dadurch gekennzeichnet,**
- **daß** es sich bei der Metallfolie (4) um eine Leiterbahn einer flexiblen Leiterplatte (1) handelt.

10. Vorrichtung zur Erzeugung einer Laserschweißverbindung zwischen einer Metallfolie (4), insbesondere Cu-Metallfolie einer flexiblen Leiterplatte (1) und einem metallischen Kontaktpartner (6), mit
- einer Halterung (11), insbesondere Träger, mit einer Montageöffnung (12) für die Metallfolie (4),
- einem Manipulator mit Manipulatorarmen (16), mittels welchem eine Verbindungsfläche (7) des metallischen Kontaktpartners (6) und ein freiliegender Bereich der Metallfolie (4) in Anlage zueinander bringbar sind,
- einem von der gegenüberliegenden Seite der Metallfolie (4) auf die Metallfolie (4) durch die Montageöffnung (12) aufdrückbaren Niederhalter (8) zur Sicherstellung einer spaltfreien Anlage zwischen der Verbindungsfläche (7) des Kontaktpartners (6) und der Metallfolie (4), und
- einem auf die gegenüberliegende Seite der Metallfolie (4) gerichteten Laser (17) zum Brennen einer Öffnung in eine die Metallfolie (4) abdeckende Isolationsschicht (3) und zum Bestrahlen der Metallfolie (4) mit Laserlicht (X) durch die in die Isolationsschicht (3) gebrannte Öffnung zur Bildung der Schweißverbindung zwischen der Metallfolie (4) und dem Kontaktpartner (6) im spaltfreien Anlagebereich.

11. Vorrichtung nach Anspruch 10,
**dadurch gekennzeichnet,**
- **daß** der Niederhalter (8) eine Durchtrittsöffnung (10) zur Transmission des Laserlichts (X) aufweist.

12. Vorrichtung nach Anspruch 10 oder 11,
**dadurch gekennzeichnet,**
- **daß** der Niederhalter (8) von einer Druckfeder (9) beaufschlagt und in Richtung der Federkraft beweglich an einem Tragkörper (13) angebracht ist.

13. Vorrichtung nach einem der Ansprüche 10 bis 12,
**dadurch gekennzeichnet,**
- **daß** der Laser ein Nd:YAG-Laser ist.

14. Vorrichtung nach einem der Ansprüche 10 bis 13,
**dadurch gekennzeichnet,**
- **daß** dem Laser (17) eine optische Einrichtung (19) nachgeschaltet ist, die ein Licht-Umlenksystem (20) und ein Planfeld-Objektiv (21) umfaßt.

## Claims

1. Method for producing a laser weld joint between a flexible metal film (4), in particular Cu film of a flexible printed circuit board (1) and a metallic contact partner (6), wherein
- a joint surface (7) of the metallic contact partner (6) is brought into contact with an exposed region on one side of the metal film (4),
- laser light (X) is directed onto the opposing side of the metal film (4), such that an opening is burned into an insulating layer (3) covering the metal film (4),
- gap-free contact between the metal film (4) and the joint surface (7) of the contact partner (6) is ensured by a pressure applied by a holder (8) to the opposing side of the metal film (4), and
- a weld joint is created between the metal film (4) and the contact partner (6) by irradiating the metal film (4) with laser light (X) through the opening burned into the insulating layer (3).

2. Method according to claim 1,
**characterised in that**
- the laser light (X) reaches the metal film (4) by way of a through opening (10) in the holder (8).

3. Method according to one of the preceding claims,
**characterised in that**
- the metallic contact partner (6) is made from a bronze alloy with a proportion of tin of maximum 14%.

4. Method according to one of the preceding claims,
**characterised in that**
- the metallic contact partner (6) is made from a bronze alloy with a lead content of maximum 1%.

5. Method according to one of the preceding claims,
**characterised in that**
- the metallic contact partner (6) is made from a bronze alloy with a nickel or zinc content of maximum 0.1%.

6. Method according to one of the preceding claims,
**characterised in that**
- the diameter of a light spot produced by the laser (17) on the metal film (4) is set between 0.3 and 0.6 mm.

7. Method according to one of the preceding claims,
**characterised in that**
- a weld energy of 8 to 18 J is used to produce the weld joint.

8. Method according to one of the preceding claims,
**characterised in that**
- a pulse peak power 2 to 3 kW of the laser (17) is used with a pulse time of 3 ms to 10 ms.

9. Method according to one of the preceding claims,
**characterised in that**
- the metal film (4) is a printed conductor of a flexible printed circuit board (1).

10. Device for producing a laser weld joint between a metal film (4), in particular Cu metal film of a flexible printed circuit board (1), and a metallic contact partner (6), with
- a support (11), in particular a carrier with an assembly opening (12) for the metal film (4),
- a manipulator with manipulator arms (16), which can be used to bring a joint surface (7) of the metallic contact partner (6) and an exposed region of the metal film (4) in contact with each other,
- a holder (8) that can be pushed down onto the metal film (4) from the opposing side of the metal film (4) through the assembly opening (12), to ensure a gap-free contact between the joint surface (7) of the contact partner (6) and the metal film (4), and
- a laser (17) directed onto the opposing side of the metal film (4) to burn an opening into an insulating layer (3) covering the metal film (4) and to irradiate the metal film (4) with laser light (X) through the opening burned into the insulating layer (3) to create the weld joint between the metal film (4) and the contact partner (6) in the gap-free contact region.

11. Device according to claim 10,
**characterised in that**
- the holder (8) has a through opening (10) to transmit the laser light (X).

12. Device according to claim 10 or 11,
**characterised in that**
- the holder (8) is subject to the action of a compression spring (9) and is attached to a carrier element (13) in such a manner that it can be moved in the direction of the spring force.

13. Device according to one of claims 10 to 12,
**characterised in that**
- the laser is an Nd:YAG laser.

14. Device according to one of claims 10 to 13,
**characterised in that**
- an optical facility (19) is connected downstream of the laser (17), having a light deflection system (20) and a plane field lens (21).

## Revendications

1. Procédé pour produire un joint de soudure par laser entre une feuille métallique flexible (4), en particulier une feuille en cuivre d'un circuit imprimé flexible (1), et un partenaire de contact métallique (6), dans lequel
- une surface de connexion (7) du partenaire de contact métallique (6) est mise en contact avec une zone dégagée sur un côté de la feuille métallique (4),
- de la lumière laser (X) est dirigée sur le côté opposé de la feuille métallique (4) de telle manière qu'une ouverture est brûlée dans une couche d'isolant (3) recouvrant la feuille métallique (4),
- un contact sans jeu de la feuille métallique (4) avec la surface de connexion (7) du partenaire de contact (6) est assuré au moyen d'une force de pression exercée par un serre-flan (8) sur le côté opposé de la feuille métallique (4), et
- un joint soudé est formé par l'irradiation de la feuille métallique (4) avec de la lumière laser (X) à travers l'ouverture brûlée dans la couche d'isolant (3) entre la feuille métallique (4) et le partenaire de contact (6).

2. Procédé selon la revendication 1, **caractérisé en ce**
- **que** la lumière laser (X) arrive sur la feuille métallique (4) en traversant une ouverture de passage (10) du serre-flan (8).

3. Procédé selon l'une des revendications précédentes, **caractérisé en ce**
- **que** le partenaire de contact métallique (6) se compose d'un alliage de bronze ayant une teneur en étain de 14% au maximum.

4. Procédé selon l'une des revendications précédentes, **caractérisé en ce**
- **que** le partenaire de contact métallique (6) se compose d'un alliage de bronze ayant une teneur en plomb de 1% au maximum.

5. Procédé selon l'une des revendications précédentes, **caractérisé en ce**
- **que** le partenaire de contact métallique (6) se compose d'un alliage de bronze ayant une teneur en nickel ou en zinc de 0,1% au maximum.

6. Procédé selon l'une des revendications précédentes, **caractérisé en ce**
- **que** le diamètre d'un point lumineux produit par le laser (17) sur la feuille métallique (4) est ajusté à une valeur comprise entre 0,3 et 0,6 mm.

7. Procédé selon l'une des revendications précédentes, **caractérisé en ce**
- **qu'**une énergie de soudure comprise entre 8 et 18 J est appliquée pour produire le joint par soudure.

8. Procédé selon l'une des revendications précédentes, **caractérisé en ce**
- **qu'**une puissance d'impulsions de pointe du laser (17) de 2 à 3 kW est employée pendant une durée d'impulsions comprise entre 3 et 10 ms.

9. Procédé selon l'une des revendications précédentes, **caractérisé en ce**
- **que** la feuille métallique (4) est la piste conductrice d'un circuit imprimé flexible (1).

10. Dispositif pour produire un joint de soudure par laser entre une feuille métallique (4), en particulier une feuille en cuivre d'un circuit imprimé flexible (1), et un partenaire de contact métallique (6), comprenant
- un support (11) pour la feuille métallique (4), en particulier un porteur, comportant une ouverture de montage (12),
- un manipulateur comportant des bras de manipulation (16) au moyen duquel une surface de connexion (7) du partenaire de contact métallique (6) et une zone dégagée de la feuille métallique (4) peuvent être mises en contact l'une avec l'autre,
- un serre-flan (8) pouvant appuyer sur la feuille métallique (4) depuis le côté opposé de la feuille métallique (4) à travers l'ouverture de montage (12) pour assurer un contact sans jeu entre la surface de connexion (7) du partenaire de contact (6) et de la feuille métallique (4), et
- un laser (17) dirigé sur le côté opposé de la feuille métallique (4) pour brûler une ouverture dans une couche d'isolant (3) recouvrant la feuille métallique (4) et pour irradier la feuille métallique (4)avec de la lumière laser (X) à travers l'ouverture brûlée dans la couche d'isolant (3) afin de former le joint de soudure entre la feuille métallique (4) et le partenaire de contact (6) dans la zone de contact sans jeu.

11. Dispositif selon la revendication 10, **caractérisé en ce**
**que** le serre-flan (8) comprend une ouverture de passage (10) pour la transmission de la lumière laser (X).

12. Dispositif selon la revendication 10 ou 11, **caractérisé en ce**
- **que** le serre-flan (8) est chargé par un ressort de pression (9) et est fixé sur un corps de support (13) de manière mobile dans la direction de la force de ressort.

13. Dispositif selon l'une des revendications 10 à 12, **caractérisé en ce**
- **que** le laser est un laser Nd:YAG.

14. Dispositif selon l'une des revendications 10 à 13, **caractérisé en ce**
- **qu'**un dispositif optique (19) est placé en aval du laser (17) qui comprend un système de déviation de lumière (20) et un objectif à champ plan (21).
